# EUROPÄISCHE PATENTSCHRIFT

(11) **EP 1 706 908 B1**
(45) Veröffentlichungstag und Bekanntmachung des Hinweises auf die Patenterteilung: **05.10.2011**
(21) Anmeldenummer: 04816261.4
(22) Anmeldetag: 16.12.2004
(51) Int. Cl.: H01L 31/18, C23C 16/24, C23C 16/509

(54) **HERSTELLUNGSVERFAHREN FÜR STAPELSOLARZELLEN UMFASSEND MIKROKRISTALLINEM SILIZIUMSCHICHTEN**
PRODUCTION METHOD FOR TANDEM SOLAR CELLS COMPRISING MICROCRYSTALLINE SILICON LAYERS
PROCEDE DE FABRICATION DE CELLULES SOLAIRES EN TANDEM CONTENANT DES COUCHES DE SILICIUM MICROCRISTALLINE

(30) Priorität: 23.01.2004 DE 102004003761
(43) Veröffentlichungstag der Anmeldung: 04.10.2006
(73) Patentinhaber: Forschungszentrum Jülich GmbH, 52425 Jülich (DE)
(72) Erfinder: REPMANN, Tobias, 63755 Alzenau (DE); RECH, Bernd, 12159 Berlin (DE)
(86) Internationale Anmeldenummer: PCT/DE2004/002752
(87) Internationale Veröffentlichungsnummer: WO 2005/071761

(56) Entgegenhaltungen:
- EP-A- 1 041 646
- ROSCHEK T ET AL: "Comprehensive study of microcrystalline silicon solar cells deposited at high rate using 13.56 MHz plasma-enhanced chemical vapor deposition" JOURNAL OF VACUUM SCIENCE AND TECHNOLOGY A. VACUUM, SURFACES AND FILMS, AMERICAN INSTITUTE OF PHYSICS, NEW YORK, NY, US, Bd. 20, Nr. 2, März 2002 (2002-03), Seiten 492-498, XP012005984 ISSN: 0734-2101
- KROLL U ET AL: "FAST DEPOSITION OF A-SI:H LAYERS AND SOLAR CELLS IN A LARGE-AREA (40X40 CM2) VHF-GD REACTOR" AMORPHOUS AND HETEROGENEOUS SILICON THIN FILMS : FUNDAMENTALS TO DEVICES - 1999. SAN FRANCISCO, CA APRIL 5 - 9, 1999, MATERIALS RESEARCH SOCIETY SYMPOSIUM PROCEEDINGS. VOL. 557, WARRENDALE, PA : MRS, US, Bd. VOL. 557, 5. September 1999 (1999-09-05), Seiten 121-126, XP000895194 ISBN: 1-55899-464-5
- ROSCHEK T ET AL: "High rate deposition of microcrystalline silicon solar cells using 13.56 MHz PECVD-prerequisites and limiting factors" AMORPHOUS AND HETEROGENEOUS SILICON-BASED FILMS - 2002. SYMPOSIUM 2-5 APRIL 2002 SAN FRANCISCO, CA, USA, Bd. 715, 2002, Seiten 635-640, XP008047557 Amorphous and Heterogeneous Silicon-Based Films - 2002. Symposium (Materials Research Society Symposium Proceedings Vol.715) Mater. Res. Soc Warrendale, PA, USA ISBN: 1-55899-651-6
- RECH B ET AL: "Amorphous and microcrystalline silicon based solar cells and modules on textured zinc oxide coated glass substrates" AMORPHOUS AND NANOCRYSTALLINE SILICON-BASED FILMS - 2003 SYMPOSIUM 22-25 APRIL 2003 SAN FRANCISCO, CA, USA, Bd. 762, 2003, Seiten 285-295, XP008047554 Amorphous and Nanocrystalline Silicon-Based Films - 2003 Symposium (Mater. Res. Soc. Symposium Proceedings Vol.762) Mater. Res. Soc Warrendale, PA, USA ISBN: 1-55899-699-0
- PLATZ R ET AL: "Influence of excitation frequency, temperature, and hydrogen dilution on the stability of plasma enhanced chemical vapor deposited a-Si:H" JOURNAL OF APPLIED PHYSICS, AMERICAN INSTITUTE OF PHYSICS. NEW YORK, US, Bd. 84, Nr. 7, 1. Oktober 1998 (1998-10-01), Seiten 3949-3953, XP012045976 ISSN: 0021-8979
- GUO, L. ET AL.: "High rate deposition of micrcrystalline silicon using conventional plasma-enhanced chemical vapor deposition" JPN. J. APPL. PHYS., Bd. 37,2.Teil, Nr. 10A, 1. Oktober 1998 (1998-10-01), Seiten L1116-L1118, XP008047612

## Beschreibung

Die Erfindung betrifft ein Verfahren zur Herstellung von mikrokristallinem Silizium (µc-Si), insbesondere von (µc-Si:H) p-i-n solarzellen sowie Stapelsolarzellen aus amorphem (α-Si:H) und mikrokristallinem Silizium in p-i-n/p-i-n Struktur. Die Erfindung betrifft ferner eine Vorrichtung zur Durchführung des Herstellungsverfahrens.

### Stand der Technik

Nach dem heutigen Stand der Technik werden µc-Si:H Solarzellen sowie α-Si:H/µc-si:H Solarzellen üblicherweise in Mehrkammer-Plasma-CVD Anlagen hergestellt. Der Vorteil bei diesem PECVD- (= plasma enhanced chemical vapor deposition) Verfahren ist, dass regelmäßig eine Kontamination der intrinsischen Absorberschicht (i-Schicht) durch Bor-Verschleppung von Reaktorwänden und der Elektrodenfläche aus der zuvor hergestellten p-Schicht vermieden wird. Nachteilig sind Mehrkammerprozesse zeitaufwändig und damit kostenintensiv.

Die Herstellung in Einkammer-Prozessen kann zwar prinzipiell realisiert werden, jedoch sind diese bislang, in der Regel nur mit aufwändigen Methoden, wie beispielsweise mit einer Plasmabehandlung oder dem zwischenzeitlichen Ausschleusen der zu beschichtenden Substrate, durchgeführt worden. Diese Herstellungsverfahren sind daher bislang für eine industrielle Produktion wenig geeignet.

Einkammer-Prozesse, die auf diese aufwändigen Methoden verzichten können, sind seit langem für die Herstellung von amorphen Solarzellen bekannt [1]. Aus EP 1 041 646 A1 ist bekannt, die mikrokristalline p-i-n-Struktur einer Solarzelle in einem Einkammerprozess herzustellen. Zur Herstellung von µc-si:H Solarzellen werden demgegenüber sehr hohe Wasserstoffverdünnungen benötigt, die sich aber als besonders kritisch im Hinblick auf die Verschleppungsproblematik herausgestellt haben. H₂-Plasmen sind regelmäßig sehr reaktiv und weisen ätzende Eigenschaften auf [2].

Die Herstellung einer µc-Si:H Solarzellen im Einkammer-Prozess wurde 2003 auf der "3rd World Conference on Photovoltaic Energy Conversion" in Osaka, Japan, vorgestellt. Dort wurde offenbart, dass in einem kommerziellen Einkammer-Reaktor, der bisher zur Herstellung von α-Si:H Solarzellenmodulen verwendet wurde, nunmehr µc-Si:H Solarzellen im Einkammer-Verfahren hergestellt wurden [3]. Als Prozessparameter wurden der Einsatz eines SnO₂-Substrats, RF-PECVD Abscheidung bei 13,56 MHz und mit Wasserstoff hoch verdünntes Silan als Reaktionsgas genannt. Eine 12" x 15" Elektrode wurde zur gleichzeitigen Beschichtung von vier jeweils 12"x 15"-Substraten eingesetzt. Durch das gleichzeitige Beschichten konnte vorteilhaft die sehr langsame Wachstumsrate für µc-Silizium kompensiert werden. Die Substrattemperatur lag bei 200 °C. Zur Überprüfung der Qualität der hergestellten Schichten wurden Lichtstrom-Spannungskurven (I-V), Dunkelstrom-Spannungskurven (I-V) und der spektrale Respons (QE) gemessen. Es wurden ca. 5 % Wirkungsgrad auf einer Fläche von 0.146 cm² erzielt. Als Ursprung für extreme Inhomogenitäten wurde eine unzureichende Gasverteilung bei Verwendung hoher HF-Leistungen genannt.

Der gegenwärtige Stand der Technik für µc-Si:H Solarzellen, so wie sie derzeit durch Mehrkammerprozesse hergestellt werden können, kann mit den vorgenannten Einkammerprozessen jedoch in Bezug auf erreichte Wirkungsgrade und Homogenität bei weitem nicht erreicht werden.

### Aufgabe und Lösung

Aufgabe der Erfindung ist es, ein einfaches, kostengünstiges und für den industriellen Einsatz geeignetes Verfahren zur Herstellung von Stapel-Solarzellen mit µc-Si:H Schichten zur Verfügung zu stellen.

Die Aufgabe der Erfindung wird gelöst durch ein Verfahren mit der Gesamtheit an Merkmalen gemäß Hauptanspruch. Vorteilhafte Ausführungsformen finden sich in den rückbezogenen Ansprüchen.

### Gegenstand der Erfindung

Das erfindungsgemäße Verfahren zur Herstellung von Stapel-Solarzellen komplett in einem Einkammer-Prozess bewirkt insbesondere großflächige, homogene Abscheidungen, die sich in deutlich höheren Wirkungsgraden wiederspiegeln, als bislang mit Einkammer-Prozessen erzielt wurden. Das Verfahren überwindet ferner das Problem der nachteiligen Borkontamination in den intrinsischen µc-Siliziumschichten.

Es konnte gezeigt werden, dass mittels PECVD bei 13,56 MHz µc-Si:H auf Flächen bis zu 30 x 30 cm² homogen hergestellt werden können und dass sich damit hohe Wirkungsgrade in Dünnschichtsolarzellen erzielen lassen. Das Depositionsregime ist gekennzeichnet durch die Verwendung eines hohen Depositionsdrucks und hohe HF- Leistungen. Diese Kombination ist für hohe Abscheideraten bei gleichzeitig guter Materialqualität verantwortlich.

Auf diesem Prozess basiert das erfindungsgemäße EinkammerVerfahren. Das Verfahren zur Herstellung von homogenen µc-Siliziumschichten auf einem Substrat, insbesondere der i- und p-Schichten für eine Solarzelle mit Hilfe der Plasma-CVD bei 13,56 MHz, wird in einem Depositionsregime durchgeführt, welches durch die nachfolgend aufgeführten Prozessparameter charakterisiert werden kann. Zusätzlich ist ein Prozessfensterbereich aufgeführt, der nach derzeitigem Wissensstand als besonders geeignet gilt. Dieses Prozessfenster kann jedoch beispielsweise erweitert werden, wenn höhere Frequenzen zur Abscheidung herangezogen werden. Für diesen Fall würde sich das Prozessfenster gegebenenfalls hin zu kleineren Drücken sowie größeren Silankonzentrationen erweitern.

Prozessparameter für µc-Si:H Absorberschicht (i-Schicht):

| Parameter | bekannter MK-Prozess | Ausführungs-beispiel für EK-Prozess | angenommenes Prozessfenster für EK-Prozess |
|---|---|---|---|
| Elektrodenab-stand | 10 mm | 12,5 mm | 5 bis 15 mm |
| Gasverteilung | Showerhead, 9 mm Raster, Gasverteilung 3-stufig | Showerhead, 9 mm Raster, Gasverteilung 3-stufig | Showerhead, Raster < Elek-trodenabstand |
| H₂-Gasfluss | 2,4 sccm/cm² (24 slm/m²) | 1,4 sccm/cm² (14 slm/m²) | >0,3 sccm/cm² (> 3 slm/m²) für Homogenität |
| SiH₄-Gasfluss | 0,02 sccm/cm² (0,2 slm/m²) | 0,02 sccm/cm² (0,2 slm/m²) | 0,01-3 sccm/cm² (0,1-30 slm/m²) |
| Prozessdruck | 13 hPa | 10,4 hPa | 3 bis 50 hPa |
| Substrat-temperatur | 150 °C | 150 °C | 50 - 220 °C |
| HF-Leistung | 0,35 W/cm² | 0,35 W/cm² | 0,2 - 2 W/cm² |

Prozessparameter für µc-Si:H p-Schicht:
Die µc-Si:H p-Schicht wird analog zur i-Schicht in einem Depositionsregime unter Verwendung von hohem Depositionsdruck und hoher HF-Leistung hergestellt. Die Silankonzentration wird im Vergleich zur i-Schicht niedriger eingestellt und beträgt beispielsweise 0,004 sccm/cm² SiH₄ (0,04 slm/m²) und 1,43 sccm/cm² H₂ (14,3 slm/m²).

Bei dem erfindungsgemäßen Verfahren wird üblicherweise mit einer Plasmaanregungsfrequenz von 13,56 MHz gearbeitet, wobei aber auch andere, insbesondere höhere Anregungsfrequenzen, wie beispielsweise 27 oder 40,5 MHz (n-faches von 13,56 MHz) möglich sind.

Optional können bei der Herstellung von Solarzellen mit mikrokristallinen Siliziumschichten auch noch Pufferechichten aufgebracht werden. Die Verwendung einer Pufferschicht mit hoher H₂- Verdünnung an der p/i-Grenzfläche bewirkt vorteilhaft eine weitere Reduzierung der Verschleppungsproblematik.

Prozessparameter für eine optionale µc-Si:H Pufferschicht: Eine geeignete µc-Si:H Pufferschicht kann wie die µc-Si:H p-Schicht und i-Schicht in einem Depositionsregime unter Verwendung von hohem Depositionsdruck und hoher HF-Leistung hergestellt werden. Die Silankonzentration, bzw. der Silanfluss wird dabei so groß wie für die µc-Si:H p-Schicht eingestellt, jedoch wird die Pufferschicht intrinsisch, das bedeutet ohne Zugabe von Dotiergas abgeschieden.

Die Wirkungsweise einer Solarzelle ist in der Regel umso besser, je schärfer der Übergang der p-Schicht zur i-Schicht ist, d. h. der Bereich, in dem die Rekombinationen stattfinden. Üblicherweise kommt es beim Abscheiden der i-Schicht auf einer hochdotierten P-Schicht zu Verschleppungen, bei der Bor in die i-Schicht eingeschleust wird. Es hat sich herausgestellt, dass es auch vorteilhaft sein kann, zunächst eine schwach dotierte Pufferschicht von 5 bis 100 nm, bei der nur eine schwache Bordotierung im Bereich von 1*10¹⁷ bis 1*10¹⁸ Atome/cm³ vorliegt, auf die hochdotierte p-Schicht aufzubringen, und erst darauf die i-Schicht abzuscheiden. Dabei fallen die Borverschleppungen vorteilhaft deutlich geringer aus und die gebildete Schichtenfolge ist in der Regel reproduzierbarer.

Die zur Durchführung des erfindungsgemäßen Verfahrens geeignete Vorrichtung weist neben einer üblichen PECVD Apparatur eine optimierte Showerhead Elektrode auf, die für eine homogene Gasverteilung und -Zuführung sowie zur Einkopplung der HF-Leistung verantwortlich ist. Damit sind insbesondere großflächige homogene Beschichtungen möglich. Die Verteilungsstufen sind von den Leitwerten auf das Depositionsregime abgestimmt.

### Spezieller Beschreibungsteil

Nachfolgend wird der Gegenstand der Erfindung anhand von Figuren und Ausführungsbeispielen näher erläutert, ohne dass der Gegenstand der Erfindung dadurch beschränkt wird.

Es wurden µc-Si:H Solarzellenmodule mit bis zu 7,7 % Wirkungsgrad bei einer Aperturfläche (wirksam eingesetzte Fläche) von 64 cm² und α-Si:H/µc-Si:H Module mit Wirkungsgraden bis zu 10,6 % bei einer Aperturfläche von ebenfalls 64 cm² mit dem erfindungsgemäßen Einkammerverfahren hergestellt. Diese Werte entsprechen dem Stand der Technik, wie er für bekannte Mehrkammerprozesse angegeben wird. Die Prozessparameter für den erfindungsgemäßen Einkammerprozess sind dabei der Tabelle zu entnehmen. Als Substrat wurde texturiertes ZnO eingesetzt. Die Depositionsrate betrug ca. 30 nm/min. Die Schichtdicken der Si-Schichten betrugen weniger als 2 µm. Als Kontakt wurde ZnO/Ag eingesetzt. Zur Überprüfung der Leistung der hergestellten Solarzelle wurde die Standardmessung (STC) vorgenommen (AM 1,5, 100 mW/cm², 25 °C). Damit ist das erfindungsgemäße Einkammerverfahren besonders geeignet, Solarzellen auch für größere Flächen industriell herzustellen. Eine Hochskalierung des Verfahrens auf Flächengrößen von 1 x 1 m oder auch größer stellt dabei in der Regel kein Problem dar.

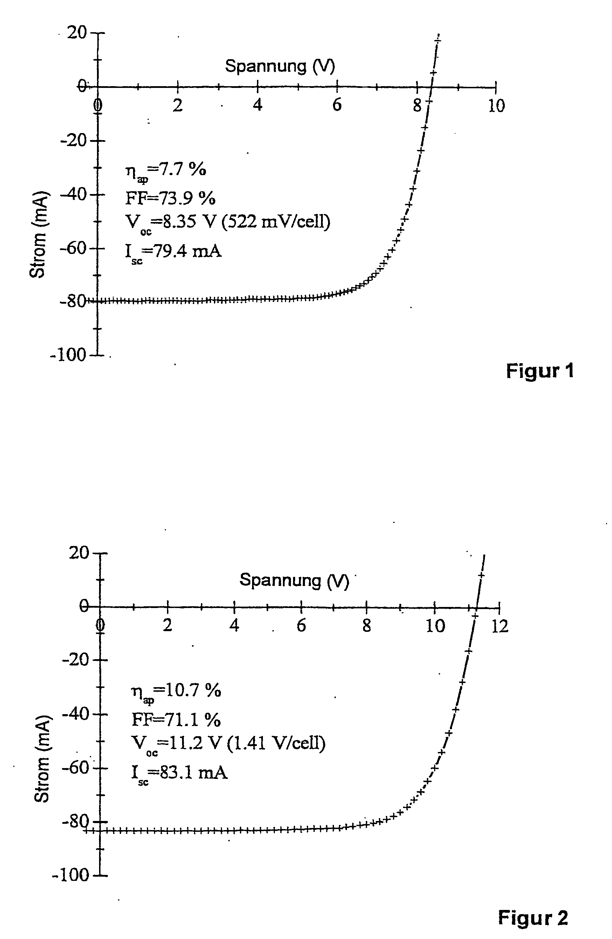

Es zeigen
- Figur 1:: Die Strom-Spannungskurve eines serienverschalteten µc-Si:H Moduls mit einer Aperturfläche von 64 cm², hergestellt mit dem erfindungsgemäßen Einkammer-PECVD-Verfahren.
- Figur 2:: Strom-Spannungskurve eines serienverschalteten α-Si:H/µc-Si:H Module mit einer Aperturfläche von 64 cm², ebenfalls hergestellt mit dem erfindungsgemäßen Einkammer-PECVD-Verfahren.

Eine zusätliche Pufferschicht an der kritischen p/i-Grenzfläche in Kombination mit dem genannten Depositionsregime führt bei der Herstellung von µc-Si:H Solarzellen mit einem Einkammerprozess in der Regel ebenfalls zu hohen Wirkungsgraden und bietet zudem den Vorteil, dass die Eigenschaften regelmäßig reproduzierbarer eingestellt werden können. Darüber hinaus hat sich heraus gestellt, dass der n/p-Übergang bei der Herstellung von α-Si:H/µc-Si:H Solarzellen in diesem Depositionsregime gleichfalls hochwertiger hergestellt werden kann. Die amorphen Solarzellen innerhalb der α-Si:H/µc-Si:H Solarzellen können ebenfalls unter Verwendung einer Pufferschicht an der p/i-Grenzfläche hergestellt werden.

In der Anmeldung zitierte Literatur:
[1] A.E. Delahoy, F.B. Ellis, Jr., E. Eser, S. Gau, H. Volltrauer, Z. Kiss, 6th E.C. Photovoltaic Energy Conf., London, (1984), 670
[2] R. Platz, D. Fischer, S. Dubail, A. Shah, Sol. Enery Mat. and Sol. Cells 46 (1997), 157
[3] Y.-M. Li, J.A. Anna Selvan, L. Li, R.A. Levy, A.E. Delahoy, Proceedings of 3rd World Conf. on Photovoltaic Energy Conv., Japan (2003), vol. 2, 1788-1791.

## Patentansprüche

1. Verfahren zur Herstellung von Stapelsolarzellen aus amorphem (α-Si:H) und mikrokristallinem (µc-Si:H) Silizium umfassend zwei p-i-n-Schichtenfolgen mit Hilfe eines PE-CVD-Verfahrens,
**dadurch gekennzeichnet, dass**
- alle Schichten der p-i-n Schichtenfolgen in einem Einkammerprozess abgeschieden werden,
und im übrigen bei der Abscheidung der mikrokristallinen i-Schicht:
- der Elektrodenabstand zwischen 5 und 15 mm beträgt,
- die Gasverteilung über einen Showerhead-Gaseinlass erfolgt, der eine homogene Verteilung des Gases über das Substrat gewährleistet,
- ein SiH₄-Gasfluss zwischen 0,01 und 3 sccm/cm² und ein H₂-Gasfluss > 0,3 sccm/cm² eingestellt wird,
- ein Prozessdruck zwischen 3 und 50 hPa eingestellt wird,
- die Heizertemperatur für das Substrat zwischen 50 und 280 °C eingestellt wird,
- und die HF-Leistung zwischen 0,2 und 2 Watt/cm² eingestellt wird.

2. Verfahren nach Anspruch 1, bei dem der Elektrodenabstand zwischen 10 und 15 mm beträgt.

3. Verfahren nach Anspruch 1 oder 2, bei dem der Showerhead-Gaseinlass ein Raster aufweist, welches kleiner als der gewählte Elektrodenabstand ist.

4. Verfahren nach einem der Ansprüche 1 bis 3, bei dem ein H₂-Gasfluss > 0,3 bis 30 sccm/cm², insbesondere > 0,3 bis 10 sccm/cm² eingestellt wird.

5. Verfahren nach einem der Ansprüche 1 bis 4, bei dem ein SiH₄-Gasfluss zwischen 0,01 und 1 sccm/cm² eingestellt wird.

6. Verfahren nach einem der Ansprüche 1 bis 5, bei dem ein Prozessdruck zwischen 8 und 15 hPa eingestellt wird.

7. Verfahren nach einem der Ansprüche 1 bis 6, bei dem die Heizertemperatur für das Substrat zwischen 80 und 180 °C eingestellt wird.

8. Verfahren nach einem der Ansprüche 1 bis 7, bei dem wenigstens eine homogene µc-Siliziumschicht auf einem Substrat mit einer Größe von mehr als 20 x 20 cm, insbesondere von mehr als 30 x 30 cm, abgeschieden wird.

9. Verfahren nach einem der Ansprüche 1 bis 8, bei dem ein texturiertes ZnO Substrat eingesetzt wird.

10. Verfahren nach einem der Ansprüche 1 bis 9, bei dem zwischen der mikrokristallinen p- und i-Schicht eine zusätzliche Pufferschicht abgeschieden wird.

11. Verfahren nach einem der Ansprüche 1 bis 10, bei dem Substrate von mehr als 30 x 30 cm, insbesondere von mehr als 50 x 50 cm, und insbesondere von mehr als 1 x 1 m homogen beschichtet werden.

12. nach einem der Ansprüche 1 bis 11, bei dem eine höhere Plasmaanregungsfrequenz gewählt wird, insbesondere ein Vielfaches von 13,56 MHz.

## Claims

1. Method for producing stacked solar cells from amorphous (α-Si:H) and microcrystalline (µc-Si:H) silicon comprising two p-i-n layer sequences with the aid of a PE-CVD method, **characterised in that**
- all the layers of the p-i-n layer sequence are deposited in a single chamber process,
and also in the deposition of the microcrystalline i-layer:
- the electrode spacing ranges between 5 mm and 15 mm,
- the gas distribution takes place via a showerhead gas inlet, which ensures a homogeneous distribution of the gas over the substrate,
- an SiH₄ gas flow is set to between 0.01 sccm/cm² and 3 sccm/cm² and an H₂ gas flow > 0.3 sccm/cm²,
- a process pressure is set between 3 hPa and 50 hPa,
- the heater temperature for the substrate is set to between 50°C and 280°C,
- and the HF output is set to between 0.2 Watt/cm² and 2 Watt/cm².

2. Method according to claim 1, wherein the electrode spacing is between 10 mm and 15 mm.

3. Method according to claim 1 or 2, wherein the showerhead gas inlet comprises a grid which is smaller than selected electrode spacing.

4. Method according to one of the claims 1 to 3, wherein an H₂ gas flow is set in the range of > 0.3 sccm/cm² to 30 sccm/cm², particularly > 0.3 sccm/cm² to 10 sccm/cm².

5. Method according to one of the claims 1 to 4, wherein an SiH₄ gas flow is set to between 0.01 sccm/cm² and 1 sccm/cm².

6. Method according to one of the claims 1 to 5, wherein a process pressure is set to between 8 hPa and 15 hPa.

7. Method according to one of the claims 1 to 6, wherein the heater temperature for the substrate is set to between 80°C and 180°C.

8. Method according to one of the claims 1 to 7, wherein at least one homogeneous µc-silicon layer is deposited on a substrate measuring more than 20 x 20 cm, particularly more than 30 x 30 cm.

9. Method according to one of the claims 1 to 8, wherein a textured ZnO substrate is used.

10. Method according to one of the claims 1 to 9, wherein an additional buffer layer is deposited between the microcrystalline p and i layers.

11. Method according to one of the claims 1 to 10, wherein substrates measuring more than 30 x 30 cm, particularly more than 50 x 50 cm and more particularly more than 1 x 1 m are homogeneously coated.

12. Method according to one of the claims 1 to 11, wherein a higher plasma excitation frequency is selected, particularly a multiple of 13.56 MHz.

## Revendications

1. Procédé de fabrication de cellules solaires tandem en silicium amorphe (α-Si:H) et microcristallin (µc-Si:H) comprenant deux successions de couches p-i-n à l'aide d'un procédé de dépôt chimique en phase vapeur assisté par plasma, **caractérisé en ce que**
- toutes les couches des successions de couches p-i-n sont déposées dans un procédé à une chambre,
et par ailleurs, lors du dépôt de la couche i microcristalline :
- la distance entre les électrodes se situe dans la plage de 5 à 15 mm,
- la distribution du gaz se fait par le biais d'un système d'injection de gaz à jets parallèles qui garantit une distribution homogène du gaz sur le substrat,
- un flux de SiH₄ gaz dans la plage de 0,01 à 3 sccm/cm² et un flux de H₂ gaz > 0,3 sccm/cm² sont ajustés,
- une pression de processus dans la plage de 3 à 50 hPa est ajustée,
- la température du dispositif de chauffage du substrat est ajustée dans la plage de 50 à 280°C,
- et la puissance HF est ajustée dans la plage de 0,2 à 2 watt/cm².

2. Procédé selon la revendication 1, dans lequel la distance entre les électrodes se situe dans la plage de 10 à 15 mm.

3. Procédé selon la revendication 1 ou la revendication 2, dans lequel le système d'injection de gaz à jets parallèles présente un pas de réseau qui est plus petit que la distance entre électrodes choisie.

4. Procédé selon l'une des revendications 1 à 3, dans lequel un flux de H₂ gaz > 0,3 à 30 sccm/cm², en particulier > 0,3 à 10 sccm/cm² est ajusté.

5. Procédé selon l'une des revendications 1 à 4, dans lequel un flux de SiH₄ gaz dans la plage de 0,01 à 1 sccm/cm² est ajusté.

6. Procédé selon l'une des revendications 1 à 5, dans lequel une pression de processus dans la plage de 8 à 15 hPa est ajustée.

7. Procédé selon l'une des revendications 1 à 6, dans lequel la température du dispositif de chauffage du substrat est ajustée dans la plage de 80 à 180°C.

8. Procédé selon l'une des revendications 1 à 7, dans lequel au moins une couche de silicium µc homogène est déposée sur un substrat de dimensions supérieures à 20 x 20 cm, en particulier supérieures à 30 x 30 cm.

9. Procédé selon l'une des revendications 1 à 8, dans lequel un substrat en ZnO texturé est utilisé.

10. Procédé selon l'une des revendications 1 à 9, dans lequel une couche tampon supplémentaire est déposée entre les couches p et i microcristallines.

11. Procédé selon l'une des revendications 1 à 10, dans lequel des substrats de dimensions supérieures à 30 x 30 cm, en particulier supérieures à 50 x 50 cm et en particulier supérieures à 1 x 1 m sont revêtus de manière homogène.

12. Procédé selon l'une des revendications 1 à 11, dans lequel une fréquence d'excitation du plasma plus élevée, en particulier un multiple de 13,56 MHz, est choisie.
